# EUROPÄISCHE PATENTSCHRIFT

(11) **EP 4 154 026 B1**
(45) Veröffentlichungstag und Bekanntmachung des Hinweises auf die Patenterteilung: **12.06.2024**
(21) Anmeldenummer: 21739595.3
(22) Anmeldetag: 28.06.2021
(51) Int. Cl.: G01R 31/327, H01H 1/00, H01H 33/66, H01H 71/04, G01R 31/12

(54) **VERFAHREN ZUR ZUSTANDSBESTIMMUNG EINER ELEKTRISCHEN SCHALTANLAGE, ÜBERWACHUNGSEINHEIT FÜR EINE ELEKTRISCHE SCHALTANLAGE UND ELEKTRISCHE SCHALTANLAGE**
METHOD FOR DETERMINING THE STATE OF AN ELECTRICAL SWITCHGEAR, MONITORING UNIT FOR AN ELECTRICAL SWITCHGEAR, AND ELECTRICAL SWITCHGEAR
PROCÉDÉ DE DÉTERMINATION DE L'ÉTAT D'UN APPAREIL DE COMMUTATION ÉLECTRIQUE, UNITÉ DE SURVEILLANCE D'UN APPAREIL DE COMMUTATION ÉLECTRIQUE, ET APPAREIL DE COMMUTATION ÉLECTRIQUE

(30) Priorität: 30.07.2020 DE 102020209645
(43) Veröffentlichungstag der Anmeldung: 29.03.2023
(73) Patentinhaber: Siemens Aktiengesellschaft, 80333 München (DE)
(72) Erfinder: BAUER, Anne, 90552 Röthenbach a. d. Pegnitz (DE); MLADENOVIC, Ivana, 90556 Seukendorf (DE)
(74) Vertreter: Siemens Patent Attorneys
(86) Internationale Anmeldenummer: PCT/EP2021/067665
(87) Internationale Veröffentlichungsnummer: WO 2022/022923

(56) Entgegenhaltungen:
- EP-A1- 0 147 592
- EP-A1- 2 328 159
- STOKES A D ET AL: "CIRCUIT-BREAKER DIAGNOSTICS", ULSI SCIENCE AND TECHNOLOGY 1987. PHILADELPHIA, MAY 11 - 15, 1987; [PROCEEDINGS OF THE INTERNATIONAL SYMPOSIUM ON ULTRA LARGE SCALE INTEGRATION SCIENCE AND TECHNOLOGY], PENNINGTON, ELECTROCHEMICAL SOCIETY, US, Bd. SYMP. 1, Nr. 1988, 28. August 1988 (1988-08-28), Seiten 1-08, XP000042544,

## Beschreibung

Verfahren zur Zustandsbestimmung einer elektrischen Schaltanlage, Überwachungseinheit für eine elektrische Schaltanlage und elektrische Schaltanlage
Die vorliegende Erfindung betrifft ein Verfahren zur Zustandsbestimmung einer elektrischen Schaltanlage nach dem Oberbegriff des Patentanspruches 1, über eine Überwachungseinheit für eine elektrische Schaltanlage nach dem Oberbegriff des Patentanspruches 9 sowie eine elektrische Schaltanlage nach Patentanspruch 12.

In zahlreichen elektrotechnischen Anlagen finden sich Schaltgeräte bzw. Schaltanlagen, z. B. luft- oder gasisolierte Schalter mit Vakuumröhren oder mechanische Schaltgeräte. Insbesondere im Mittelspannungsbereich oder im Hochspannungsbereich. Diese dienen beispielsweise zum Schutz von Personen und Anlagen und sie werden bevorzugt eingesetzt, um im Fehlerfall betroffene Netzbereiche abzuschalten, insbesondere z. B. in einem Kurzschlussfall. Im Laufe der Betriebsdauer altern die Schaltgeräte, hervorgerufen durch Schaltvorgänge. Beispielsweise werden hierbei die Kontakte, insbesondere durch die Energie, die durch den Lichtbogen eingebracht wird, abgenutzt. Die Betreiber von Schaltanlagen sind bestrebt, die Schaltgeräte so lange wie möglich in ihren Anlagen einzusetzen, ohne dass die Zuverlässigkeit gefährdet ist. Deshalb ist es erstrebenswert, den Alterungszustand eines Schaltgerätes bzw. einer Schaltanlage so präzise wie möglich zu kennen und eine Prognose für die noch verfügbare Lebensdauer zu erhalten. Dies ermöglicht dem Betreiber einen rechtzeitigen Austausch, ohne ein Gerät deutlich zu früh austauschen zu müssen.

Zur Abschätzung der Lebensdauer gibt es verschiedene Vorgehensweisen. In den Datenblättern von Schaltanlagen wird typischerweise angegeben, für wie viele Schaltspiele eine Schaltanlage abhängig vom geschalteten Strom ausgelegt ist. Anhand der Historie, also der Anzahl der Schaltvorgänge und der Kenntnis der abgeschalteten Stromstärke, kann die Anzahl der noch verbleibenden Schaltspiele stromabhängig abgeschätzt werden. Dabei wird die zeitliche Dauer des Lichtbogens jedoch nicht berücksichtigt, was aber für die Bestimmung der Restlebensdauer eine wichtige Rolle spielt, da dadurch die Abnutzung der Kontakte und anderer Komponenten in größerem oder kleinerem Maße stattfinden kann. Bei Anwendung dieser Methode muss zur Sicherstellung eines zuverlässigen Schaltverlaufes ein Sicherheitspuffer an überzähligen Schaltspielen eingehalten werden und die Anlage ggf. früher ausgetauscht werden.

Eine andere Vorgehensweise ist die Bestimmung der Energie, die auf ein Schaltgerät bei den Schaltvorgängen wirkt. Diese Energie wird aus dem zeitlichen Verlauf beim Schaltvorgang durch Integration der Stromstärke bestimmt, was unter dem Begriff I²t-Methode bekannt ist. Der Wert wird für die bereits erfolgten Schaltvorgänge aufsummiert. Je nach Schaltertyp gibt es eine bestimmte Grenze für die maximale Gesamtenergie. Alternativ kann auch die durch den Lichtbogen übertragene Ladungsmenge Q bestimmt werden. Beide Methoden weisen jedoch die Notwendigkeit auf, dass zu ihrer Berechnung eine genaue Kenntnis der Lichtbogenzeit erforderlich ist.

"STOKES A D ET AL: "CIRCUIT-BREAKER DIAGNOSTICS",ULSI SCIENCE AND TECHNOLOGY 1987. PHILADELPHIA, MAY 11 - 15, 1987; [PROCEEDINGS OF THE INTERNATIONAL SYMPOSIUM ON ULTRA LARGE SCALE INTEGRATION SCIENCE AND TECHNOLOGY], PENNINGTON, ELECTROCHEMICAL SOCIETY, US, Bd. SYMP. 1, Nr. 1988, 28. August 1988 (1988-08-28), Seiten 1-8" offenbart ein Verfahren sowie eine Überwachungseinheit zur Zustandsbestimmung einer elektrischen Schaltanlage.

Die Aufgabe der Erfindung besteht darin, ein Verfahren zur Zustandsbestimmung einer elektrischen Schaltanlage sowie einer Überwachungseinheit für eine elektrische Schaltanlage und eine elektrische Schaltanlage an sich bereitzustellen, die gegenüber dem Stand der Technik noch zuverlässiger und mit weniger technischem Aufwand zu ermitteln ist.

Die Lösung der Aufgabe besteht in einem Verfahren mit den Merkmalen des Patentanspruches 1, in einer Überwachungseinheit mit den Merkmalen des Patentanspruches 9 sowie in einer Schaltanlage mit den Merkmalen des Patentanspruches 12.

Das erfindungsgemäße Verfahren zur Zustandsbestimmung einer elektrischen Schaltanlage ist dabei wie folgend ausgestaltet:

Es wird der elektrische Strom I und die über die Schaltung abfallende Spannung U gemessen. Das Verfahren zeichnet sich dadurch aus, dass ein Zeitintervall eine während eines Schaltvorganges auftretenden Lichtbogens ermittelt wird, wobei das Zeitintervall beginnt, wenn der Wert der gemessenen Spannung U einen ersten Schwellwert überschreitet; das Zeitintervall endet, wenn der Wert der Stromstärke I einen zweiten Schwellwert unterschreitet. Das so ermittelte Zeitintervall wird mit einem für die Schaltanlage spezifischen Referenzwert verglichen.

Der Vorteil des beschriebenen Verfahrens gegenüber dem Stand der Technik besteht darin, dass durch die beiden definierten Schwellwerte für die Spannung einerseits als auch für die Stromstärke andererseits die Lichtbogendauer, also das Zeitintervall, in dem der Lichtbogen auftritt, exakt definiert und gemessen werden kann. Dies liegt daran, dass bei Beginn des Lichtbogens die anliegende Spannung ausgesprochen schnell ansteigt, weshalb durch einen festgelegten Grenzwert der Zeitpunkt des Ansteigens der Spannung und der Beginn des Lichtbogens sehr exakt bestimmt werden kann. Andererseits sinkt der Strom auf 0 ab, wenn der Lichtbogen erlischt. Somit kann der zweite Grenzwert, der für die elektrische Stromstärke festgelegt ist und der in der Regel nahe bei 0 oder exakt bei 0 liegt, sehr genau das Ende der Lichtbogendauer bestimmt werden. Mit diesen beiden exakten Werten ist es einerseits möglich, die Energie, die in die Schaltanlage eingebracht wird, sehr genau zu bestimmen, andererseits kann auch das Zeitintervall, in dem der Lichtbogen auftritt, sehr genau bestimmt werden. Mit diesem genauen Zeitintervall, das auf die beschriebene Weise bestimmt ist, kann ein aussagekräftiger Vergleich mit einem anlagespezifischen Referenzwert getroffen werden. Dieser Referenzwert ist die für eine Anlage im Neuzustand bestimmte Dauer des Lichtbogens. Dieses Zeitintervall für den Referenzwert wird nach derselben Methode bestimmt, wie sie hier beschrieben ist.

Bei einer betriebsbereiten und nicht gealterten Schaltanlage ist der Unterschied, also das Δt des ermittelten Zeitintervalls und der Referenzwert, sehr gering. Vom Anlagenbetreiber oder vom Hersteller ermittelte Abweichungen zwischen dem gemessenen Zeitintervall und dem Referenzwert lassen dann Rückschlüsse über den Alterungszustand der elektrischen Schaltanlage zu und es können entsprechende Maßnahmen abgeleitet werden.

Eine weitere Möglichkeit, neben dem Vergleich des gemessenen Zeitintervalls und des Referenzwertes, ist die Bestimmung des Spannungsverlaufes während des Zeitintervalls an sich. Dieser kann zusätzlich noch mit einem Referenzspannungsverlauf einer Schaltanlage im Neuzustand verglichen werden. Dieser Vergleich des Spannungsverlaufes lässt ebenfalls weitere Rückschlüsse über den Zustand der Schaltanlage zu.

Dabei ist anzumerken, dass sowohl das reine Zeitintervall des Lichtbogens als auch der Spannungsverlauf jeweils in Abhängigkeit der zu schaltenden Stromstärke steht. D. h., sowohl der Referenzwert für das Zeitintervall als auch der Referenzspannungsverlauf sind entsprechend für verschiedene maximale Stromstärken hinterlegt, die im geschlossenen Zustand an der Schaltanlage anliegen und entsprechend durch eine Trennung von Kontakten der Schaltanlage abgeschaltet werden müssen. Sowohl die Messung der Spannung U als auch die Messung des Stromes I sollten möglichst kontinuierlich erfolgen. Da eine Messung in unendlich kurzen Zeitintervallen technisch nicht möglich ist, sollte in möglichst kurzen Zeitintervallen, also bevorzugt jede Millisekunde, sowohl eine Strom- als auch eine Spannungsmessung erfolgen. Um so kürzer die Messintervalle dieser beiden Größen sind, um so genauer kann das Zeitintervall für die Lichtbogendauer festgelegt werden. Und um so genauer sind letztendlich die Vergleichswerte mit dem Referenzwert und die Rückschlüsse auf den Anlagenzustand.

Bevorzugt wird das Verfahren angewendet bei elektrischen Schaltanlagen, die höhere Stromstärken schalten, bevorzugt Schaltanlagen der Mittelspannung und der Hochspannung, die für mindestens 16 A ausgelegt sind. Die Stromstärke ist lastabhängig, d.h. kann sich zu unterschiedlichen Zeitpunkten deutlich unterscheiden. Iₘₐₓ kann also für mehrere Schaltvorgänge unterschiedlich sein.

In einer vorteilhaften Ausgestaltungsform der Erfindung wird ein Signal generiert, wenn das Zeitintervall den Referenzwert um einen Grenzwert überschreitet. Dieses Signal kann in unterschiedlichster Form und Wirkungsweise ausgestaltet werden. Das Signal kann beispielsweise in einfachster Form in einen Fehlerspeicher, der sich an der Anlage befindet, geleitet werden und bei Bedarf dort abgerufen werden. Es könnte jedoch auch direkt an eine Leitwarte eines Stromnetzes weitergeleitet werden und dort weiterverarbeitet werden.

Der beschriebene Grenzwert, den das Zeitintervall des Lichtbogens den festgelegten Referenzwert überschreiten darf, sollte nach Untersuchung verschiedener Schaltanlagen 10 % nicht überschreiten.

Ein weiterer Bestandteil der Erfindung besteht in einer Überwachungseinheit für eine elektrische Schaltanlage mit einer Messeinheit zur Messung der durch die Schaltanlage fließenden Stromstärke und der über die Schaltanlage abfallenden Spannung. Diese Überwachungseinheit weist eine Auswerteeinheit auf, die mit einem Speicher bestückt ist. Die Überwachungseinheit zeichnet sich dadurch aus, dass in dem Speicher ein erster Schwellenwert für die anliegende Spannung sowie ein zweiter Schwellenwert für die elektrische Stromstärke festgelegt ist und die Auswerteeinheit dazu ausgestaltet ist, eine Ermittlung eines Zeitintervalls vorzunehmen, das die Dauer zwischen dem Überschreiten des ersten Schwellwertes und dem Unterschreiten des zweiten Schwellwertes umfasst, um einen Abgleich des ermittelten Fallintervalls mit einem in dem Speicher hinterlegten Referenzwert vorzunehmen.

Die Vorteile, die die Überwachungseinheit auf gegebenem Stand der Technik aufweist, wurden bereits zu dem Verfahren gemäß Patentanspruch 1 beschrieben. Bei der Überwachungseinheit handelt es sich somit um eine Einheit, die bevorzugt räumlich nah an der elektrischen Schaltanlage angeordnet ist, und als Bestandteil dieser gesamten Einheit angesehen werden kann.

Die Überwachungseinheit ist auch in zweckmäßiger Weise in der Art ausgestaltet, ein Signal zu erzeugen, wenn das Zeitintervall den Referenzwert um einen Grenzwert, der bevorzugt wiederum 10 % des Zeitintervalls beträgt, überschreitet.

Ferner ist an der Überwachungseinheit eine Kommunikationsvorrichtung vorgesehen, die dazu ausgestaltet ist, das Signal an eine dezentrale Datenverarbeitungsvorrichtung zu übertragen. Wie bereits beschrieben, kann eine dezentrale Datenverarbeitungsvorrichtung beispielsweise an eine Netzleitwarte angeschlossen sein, wodurch in der Netzleitwarte Informationen über den Zustand der überwachten Schaltanlage vorliegen.

Ein weiterer Bestandteil der Erfindung ist eine elektrische Schaltanlage, die eine Überwachungseinheit nach einem der Ansprüche 10 oder 11 umfasst. Dabei ist die elektrische Schaltanlage bevorzugt eine Mittel- oder Hochspannungsschaltanlage mit einer Auslegung für mindestens 16 kA.

Weitere Ausgestaltungsformen der Erfindung und weitere Merkmale werden anhand der folgenden Figuren näher erläutert. Dabei zeigen:
- Figur 1: eine schematische Darstellung einer elektrischen Schaltanlage mit einer an ihr angeordneten Auswerteeinheit und
- Figur 2: ein Strom-Spannungs-Diagramm während des Abschaltens einer elektrischen Schaltanlage, das durch die Auswerteeinheit aufgenommen ist.

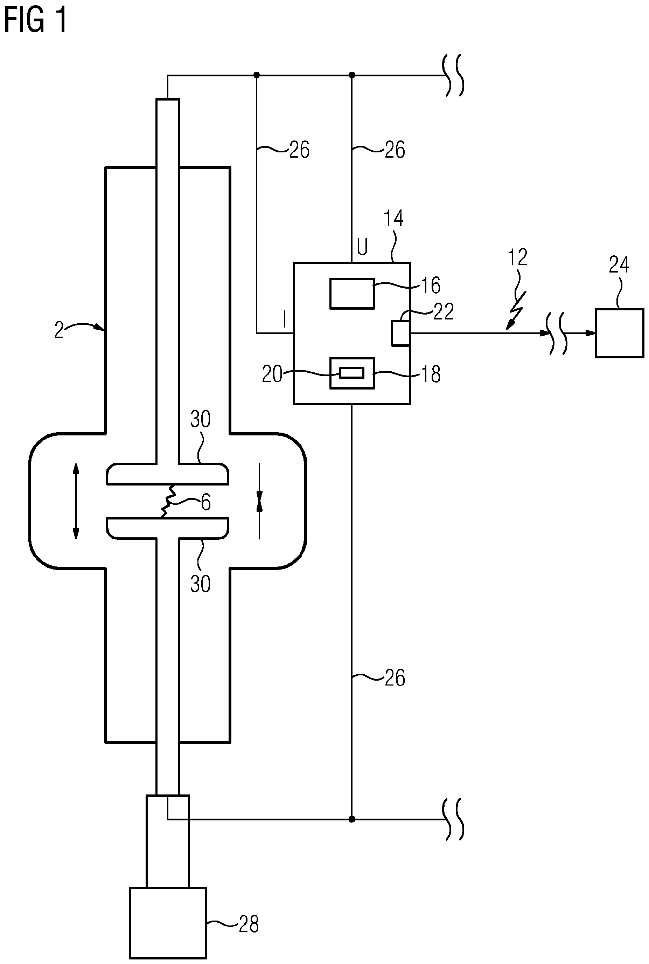

In Figur 1 ist schematisch eine elektrische Schaltanlage 2 dargestellt, die zwei Kontakte 30 aufweist, die mittels eines Antriebs 28 voneinander getrennt werden können bzw. wieder geschlossen werden können. Dies ist durch die gegenläufigen Pfeile neben den Kontakten 30 veranschaulicht. Sowohl beim Öffnen als beim Schließen der Kontakte 30 tritt bei anliegender Spannung bzw. fließendem Strom ein Schaltlichtbogen 6 auf. Dabei ist anzumerken, dass die beschriebene Kontaktform sehr vereinfachend dargestellt ist. Es kann sich hierbei um jede technisch übliche elektrische Schaltanlage, wie Vakuumschaltröhren oder gasisolierte Schaltanlagen mit Tulpe-Stiftkontakten oder, wie hier dargestellt, Tellerkontakten, handeln.

Durch den Schaltlichtbogen 6 wird lokal und punktuell eine sehr hohe Energiemenge in die Schaltanlage 2, insbesondere an die Kontakte 30, eingebracht. Hierzu kommt es temporär und lokal zu Aufschmelzungen der Kontakte, was zu einer Alterung der Kontakte 30 beiträgt. Um den Alterungszustand der elektrischen Schaltanlage genau zu bestimmen, ist es wichtig herauszufinden, inwieweit sich der Schaltlichtbogen 6 beim Ein- und Ausschalten der elektrischen Schaltanlage 2 verhält. Wie bereits beschrieben, ist es üblich, über die eingebrachte Energie eine Abschätzung des Zustandes der Schaltanlage 2 durchzuführen. Die hier beschriebene elektrische Schaltanlage 2 umfasst jedoch eine weitere Auswerteeinheit 18, die dazu geeignet ist, über Messzuführungen 26 den anliegenden elektrischen Strom I sowie die über der Schaltanlage 2 abfallenden elektrischen Spannung U kontinuierlich zu ermitteln. Kontinuierlich bedeutet dabei, dass möglichst in kurzen Messintervallen, möglichst geringer als 1 Millisekunde sowohl der Strom I als auch die Spannung U gemessen werden.

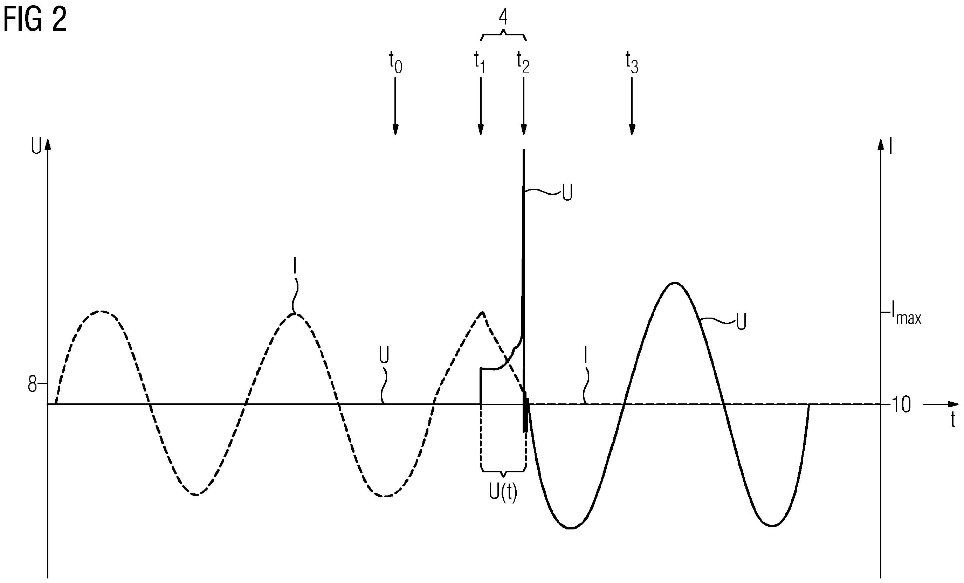

In Figur 2 ist ein grafische Darstellung der kontinuierlich gemessenen Stromstärke I und der Spannung U in einem gemeinsamen Diagramm dargestellt. Die linke y-Achse zeigt dabei die abgefallene Spannung U, die rechte y-Achse die Stromstärke I.

Wenn man auf der x-Achse, die die Zeit t darstellt, von links nach rechts folgt, so ist zunächst der sinusförmige Verlauf der Stromstärke I zu erkennen, wobei die Spannungskurve U nahe 0 liegt, da bei geschlossenen Kontakten über der Schaltanlage nur eine sehr geringe Spannung abfällt, dabei handelt es sich um die Spannung, die zum Kontaktwiderstand beiträgt, was naturgemäß sehr gering ist. Dieser zeitliche Bereich wird exemplarisch durch den Pfeil gekennzeichnet, der mit t0 bezeichnet ist.

In dem Moment, in dem der Schaltvorgang einsetzt und die beiden Kontakte 30 voneinander getrennt werden, steigt die Spannung U schlagartig an, was mit dem Pfeil gekennzeichnet ist, der durch t1 gekennzeichnet ist. Bei dem Zeitpunkt t2 ist der Schaltvorgang beendet, da in diesem Moment die Stromkurve I 0 wird. Es findet somit ein 0-Durchgang des Stromes statt, wodurch der Schaltlichtbogen 6 erlischt. Darauf folgt der offene Zustand der Schaltanlage, in der zum exemplarischen Zeitpunkt t3 kein Strom fließt.

Zwischen den Zeitpunkten t1 und t2 befindet sich ein Zeitintervall 4, in dem der Lichtbogen 6 während des Schaltvorganges auftritt.

Dabei sind die Zeitpunkte t1 und t2 folgendermaßen definiert: Zum einen gibt es einen ersten Schwellwert 8, der einen Spannungswert festlegt, bei dessen Überschreiten das Zeitintervall 4 beginnt, also der Zeitpunkt t1 definiert ist. In Figur 2 ist zu erkennen, dass zum Zeitpunkt t1 der Spannungswert U sprunghaft ansteigt. Der Schwellwert 8 ist hier schematisch dargestellt, deutlich über dem 0-Wert der Spannung U angeordnet. Somit ist mit dem Schwellwert 8 sehr genau der Zeitpunkt t1 festlegbar.

Der Zeitpunkt t2 korrespondiert im Gegensatz dazu mit einem zweiten Schwellwert 10, der auf der y-Achse aufgetragen ist, die den elektrischen Strom darstellt. Der zweite Schwellwert 10 kann dabei sehr nahe am 0-Wert des elektrischen Stromes, direkt auf dem 0-Wert oder möglicherweise auch knapp darunter liegen. Grundsätzlich kann man von einem Erlöschen des Lichtbogens 6 sprechen, wenn der elektrische Strom einen 0-Durchgang durchläuft. Technologische oder messtechnische Feinheiten können dazu führen, dass der Schwellwert 10 jedoch nicht genau am 0-Punkt von I angeordnet ist, sondern leicht darum festgelegt ist.

Figur 2 zeigt zudem, dass die elektrische Stromstärke I im geschlossenen Zustand einen sinusförmigen Verlauf annimmt. Ab dem Zeitpunkt t1 bricht der elektrische Strom I zusammen und erfährt zum Zeitpunkt t2 einen 0-Durchgang. Die elektrische Spannung U hingegen liegt während des geschlossenen Zustandes, wie bereits erwähnt, nahe 0, sie steigt bei t1 sprunghaft an und vollzieht nach dem Erlöschen des Lichtbogens 6, also nach dem Zeitpunkt t2, eine sinusförmige Schwingung, während der Strom I nach t2 auf der 0-Linie verläuft.

In dem Zeitintervall 4, also zwischen den Zeitpunkten t1 und t2, vollzieht die Spannungskurve einen vollkommen ungleichmäßigen Verlauf mit einem deutlichen Peak. Dieser Verlauf der Spannungskurve während des Zeitintervalls 4 ist an dieser Stelle mit U(t) bezeichnet. Dieser Spannungsverlauf U(t) im Zeitintervall 4 hat ebenfalls eine charakteristische Ausbildung, die auf den Zustand der Schaltanlage 2 Rückschlüsse zulässt. Eine Schaltanlage im Neuzustand hat hierbei einen anderen U(t) Verlauf als eine Schaltanlage, die schon mehrere Tausend Schaltspiele hinter sich hat. Zudem ist der Verlauf von U(t) abhängig von der zu schaltenden Stromstärke I, die hier als Iₘₐₓ und das Maximum der Sinusschwingung der Stromkurve im Diagramm der Figur 2 darstellt.

Nun ist es durch das beschriebene Verfahren einerseits möglich, eine exakte Bestimmung des Zeitintervalls 4 durch exakte Bestimmung der Zeitpunkte t1 und t2 vorzunehmen und diese mit einem Referenzwert einer neuwertigen Schaltanlage zu vergleichen. Auf der anderen Seite ist es zudem möglich, die Charakteristik der Spannungskurve im Zeitintervall 4 zwischen t1 und t2 mit einer Referenzspannungskurve, die hier nicht dargestellt ist und von einer Schaltanlage im Neuzustand herrührt, zu vergleichen. Der Vergleich der beiden Spannungsverlaufskurven ist dabei komplexer als der reine Vergleich von zwei Zahlenwerten, die das Zeitintervall 4 darstellen. Daher ist es zweckmäßig, zunächst in einfacherer Weise die beiden Zahlenwerte für das Zeitintervall, das aktuell Gemessene und das als Referenzwert Hinterlegte zu vergleichen und bei Überschreiten eines Grenzwertes, der vorher anhand von Erfahrungswerten festgelegt ist, zu prüfen, ob die aktuell betriebene Schaltanlage 2 sich noch in einem entsprechenden Zustand befindet. Falls der Grenzwert beispielsweise um 10 % überschritten ist, also wenn die Lichtbogendauer, das Zeitintervall 4, 10 % länger ist als dies bei einer neuwertigen Schaltanlage der Fall ist, so könnte dies auf eine starke Beanspruchung der Schaltanlage 2 hindeuten.

In diesem Fall wird ein Signal erzeugt, das in einem internen Speicher 20 der Überwachungseinheit 14 abgelegt wird. Ermittelt wird dabei der Unterschied zwischen dem gemessenen Zeitintervall und dem Referenzwert mittels einer Auswerteeinheit 18, die auch den Speicher 20 in der Überwachungseinheit umfasst. Dazu ist ebenfalls eine Messeinheit 16 vorgesehen, die für die Ermittlung der Messwerte der elektrischen Stromstärke I und der Spannung U zuständig ist. Somit sind die Messeinheit 16, die Auswerteeinheit 18 sowie der Speicher 20 und ggf. ein Kommunikationsmodul 22 Bestandteile der Überwachungseinheit 14, die an der elektrischen Schaltanlage 2 angeordnet ist.

Durch das Kommunikationsmodul 22 ist es möglich, ein Signal, das Informationen über den Unterschied zwischen dem Zeitintervall 4 und dem Referenzwert oder auch Informationen über einen unterschiedlichen Verlauf der U(t) Kurve mit dem Referenzspannungsverlauf umfasst, an eine dezentrale Datenverarbeitungsvorrichtung 24 zu verschicken. Diese Datenverarbeitungsvorrichtung 24 kann beispielsweise Teil einer Netzleitwarte sein, sie kann jedoch auch irgendwo in einem Cloud-Rechenzentrum allokiert sein, um Informationen an eine Leitwarte weiterzugeben. Diese Signale 12 umfassen dann Informationen über den Zustand der Schaltanlage 2. Wie bereits erwähnt, können diese in einfacherer Weise aus dem Zeitintervall 4 zwischen t1 und t2 ermittelt werden oder, mit einer komplexeren Auswertung verbunden, über den U(t) Verlauf der Spannungskurve während des Zeitintervalls 4. Grundsätzlich können diese Informationen, die hieraus ermittelt werden und das Signal 12 erzeugen, auch lokal im Speicher 20 abgelegt werden und bei routinemäßigen Auslesungen oder Wartungen der Schaltanlage 2 bzw. der Überwachungseinheit 14 von einem Servicetechniker ausgelesen werden und an einen zentralen Rechner bzw. an die zentrale Datenverarbeitungsvorrichtung 24 übermittelt werden.

Die unterschiedliche Dauer des Schaltlichtbogens mit alternden Schaltanlagen 2 rührt bei gleichen Bedingungen, also bei gleicher Stromstärke I, die abgeschaltet wird, durch eine Verunreinigung des Isolationsmediums her. Hierdurch kann eine veränderte Dauer des Lichtbogens resultieren. Die Gasverunreinigungen können z. B. durch die Abnutzung von Kontakten während der Schaltvorgänge zustande kommen. Ähnliches gilt auch für den U(t) Verlauf, also den Spannungsverlauf während des Zeitintervalls 4. In neuem Zustand der Schaltanlage sind die charakteristischen Spannungsverläufe U (t) in Abhängigkeit des Zeitpunktes des Schaltens (in der Stromverlaufskurve I sowie bezüglich des Phasenwinkels) und der Stromstärke I dem Schalter, dem Hersteller der Schaltanlage, bekannt, da dies für die Schalterauslegung relevant ist. Abweichungen von der charakteristischen Spannungskurve, also vom Referenzspannungsverlauf, deuten auf eine Verschlechterung des Zustandes der Schaltanlage 2 hin. Dies äußert sich beispielsweise durch eine Kontaktverschlechterung, wenn der Spannungsanstieg zu Beginn des Lichtbogens 6 sehr steil ist. Ebenfalls eine Verschlechterung des Zustandes der Schaltanlage resultiert in der Verschlechterung des Isolationsgases, wenn die Spannung zu Beginn des Lichtbogens lange hoch ist, also ein breiter Peak besteht.

### Bezugszeichenliste

- 2: elektrische Schaltanlage
- 4: Zeitintervall
- 6: Lichtbogen
- 8: erster Schwellwert
- 10: zweiter Schwellwert
- 12: Signal
- 14: Überwachungseinheit
- 16: Messeinheit
- 18: Auswerteeinheit
- 20: Speicher
- 22: Kommunikationsvorrichtung
- 24: dezentrale Datenverarbeitungsvorrichtung
- 26: Messzuführungen
- 28: Antrieb
- 30: Kontakte
- t₀: Spannungs-/Stromverlauf geschlossener Zustand
- t₁: Beginn Zeitintervall
- t₂: Ende Zeitintervall
- t₃: U/I Verlauf offener Zustand

## Patentansprüche

1. Verfahren zur Zustandsbestimmung einer elektrischen Schaltanlage (2), wobei der elektrische Strom (I) und die über die Schaltanlage (2) abfallende Spannung (U) gemessen wird, **dadurch gekennzeichnet, dass** ein Zeitintervall (4) eines während eines Schaltvorgangs auftretenden Lichtbogens (6) ermittelt wird, wobei das Zeitintervall (4) beginnt, wenn der Wert der gemessenen Spannung (U) einen ersten Schwellwert (8) überschreitet und das Zeitintervall (4) endet, wenn der Wert der Stromstärke (I) einen zweiten Schwellwert (10) unterschreitet, **dadurch gekennzeichnet, dass** das so ermittelte Zeitintervall (4) mit einem für die Schaltanlage (2) spezifischen Referenzwert, der nach der gleichen Methode bei einer Anlage im Neuzustand ermittelt wird, und der Zeitunterschied (Δt) des ermittelten Zeitintervalls und des Referenzwerts verglichen wird und der Spannungsverlauf (U(t)) während des Zeitintervalls (4) gemessen wird und mit einem an einer Anlage im Neuzustand gemessenen Referenzspannungsverlauf verglichen wird.

2. Verfahren nach Anspruch 1, **dadurch gekennzeichnet, dass** die Messung der Spannung (U) mindestens alle 1 ms erfolgt.

3. Verfahren nach einem der Ansprüche 1 bis 2, **dadurch gekennzeichnet, dass** die Messung des Stroms (I) mindestens alle 1 ms erfolgt.

4. Verfahren nach einem der vorhergehenden Ansprüche,
**dadurch gekennzeichnet, dass** der für die Schaltanlage (2) festgelegte Referenzwert in Abhängigkeit der maximalen Stromstärke (Iₘₐₓ) festgelegt wird, die im geschlossenen Zustand der Schaltanlage (2) an dieser anliegt.

5. Verfahren nach einem der vorhergehenden Ansprüche,
**dadurch gekennzeichnet, dass** der Referenzspannungsverlauf in Abhängigkeit der maximalen Stromstärke (Iₘₐₓ)ermittelt wird,
die im geschlossenen Zustand der Schaltanlage (2) an dieser anliegt.

6. Verfahren nach einem der Ansprüche 4 oder 5,
**dadurch gekennzeichnet, dass** die maximale Stromstärke (Iₘₐₓ), die im geschlossenen Zustand der Schaltanlage an dieser anliegt, mindestens 16 A beträgt.

7. Verfahren nach einem der vorhergehenden Ansprüche,
**dadurch gekennzeichnet, dass** ein Signal (12) generiert wird, wenn das Zeitintervall (4) den Referenzwert um einen Grenzwert überschreitet.

8. Verfahren nach Anspruch 7, **dadurch gekennzeichnet, dass** das Signal generiert wird, wenn das Zeitintervall den Referenzwert um 10 % überschreitet.

9. Überwachungseinheit (14) für eine elektrische Schaltanlage (2) mit einer Messeinheit (16) zur Messung der durch die Schaltanlage fließenden Stromstärke (I) und der über die Schaltanlage (2) abfallenden Spannung (U) sowie mit einer Auswerteeinheit (18) mit einem Speicher (20), wobei in dem Speicher (20) ein erster Schwellwert (8) für die anliegende Spannung (U) sowie ein zweiter Schwellwert (10) für die elektrische Stromstärke (I) festgelegt ist und die Auswerteeinheit (18) dazu ausgestaltet ist, eine Ermittlung eines Zeitintervalls (4) vorzunehmen, das die Dauer zwischen dem Überschreiten des ersten Schwellwertes (8) und dem Unterschreiten des zweiten Schwellwertes (10) umfasst und **dadurch gekennzeichnet, dass**
die Auswerteeinheit (18) weiterhin dazu ausgestaltet ist, einen Abgleich des so ermittelten Zeitintervalls (4) mit einem in dem Speicher (20) hinterlegten Referenzwert sowie einen Abgleich eines während des Zeitintervalls (4) gemessenen Spannungsverlaufs mit einem Referenzspannungsverlauf vorzunehmen, jeweils ermittelt an einer Anlage im Neuzustand.

10. Überwachungseinheit (14) nach Anspruch 9, **dadurch gekennzeichnet, dass** die Auswerteeinheit (18) dazu ausgestaltet ist, ein Signal (12) zu erzeugen, wenn das Zeitintervall (4) den Referenzwert um einen Grenzwert überschreitet.

11. Überwachungseinheit nach Anspruch 10, **dadurch gekennzeichnet, dass** eine Kommunikationsvorrichtung (22) vorgesehen ist, die dazu ausgestaltet ist, das Signal (12) an eine dezentrale Datenverarbeitungsvorrichtung (24) zu übertragen.

12. Elektrische Schaltanlage (2) umfassend eine Überwachungseinheit (14) nach Anspruch 10 oder 11.

13. Elektrische Schaltanlage (2) nach Anspruch 12, **dadurch gekennzeichnet, dass** diese in der Art ausgestaltet ist, Stromstärken (I) von mehr als 16 kA zu schalten.

## Claims

1. Method for determining the state of an electrical switchgear assembly (2), wherein the electric current (I) and the voltage (U) dropped across the switchgear assembly (2) are measured, **characterized in that** a time interval (4) of an arc (6) occurring during a switching operation is ascertained, wherein the time interval (4) begins when the value of the measured voltage (U) exceeds a first threshold value (8) and the time interval (4) ends when the value of the current intensity (I) falls below a second threshold value (10), **characterized in that** the time interval (4) ascertained in this way is compared with a reference value that is specific to the switchgear assembly (2) and that is ascertained using the same method for an assembly in the new state, and the time difference (Δt) between the ascertained time interval and the reference value, and the voltage profile (U(t)) is measured during the time interval (4) and is compared with a reference voltage profile measured on an assembly in the new state.

2. Method according to Claim 1, **characterized in that** the voltage (U) is measured at least every 1 ms.

3. Method according to either of Claims 1 and 2, **characterized in that** the current (I) is measured at least every 1 ms.

4. Method according to one of the preceding claims, **characterized in that** the reference value defined for the switchgear assembly (2) is defined depending on the maximum current intensity (Iₘₐₓ) present at said switchgear assembly (2) in the closed state thereof.

5. Method according to one of the preceding claims, **characterized in that** the reference voltage profile is ascertained depending on the maximum current intensity (Iₘₐₓ) present at said switchgear assembly (2) in the closed state thereof.

6. Method according to either of Claims 4 and 5, **characterized in that** the maximum current intensity (Iₘₐₓ) present at said switchgear assembly in the closed state thereof is at least 16 A.

7. Method according to one of the preceding claims, **characterized in that** a signal (12) is generated if the time interval (4) exceeds the reference value by a limit value.

8. Method according to Claim 7, **characterized in that** the signal is generated if the time interval exceeds the reference value by 10%.

9. Monitoring unit (14) for an electrical switchgear assembly (2), comprising a measuring unit (16) for measuring the current intensity (I) flowing through the switchgear assembly and the voltage (U) dropped across the switchgear assembly (2), and comprising an evaluation unit (18) with a memory (20), wherein a first threshold value (8) for the present voltage (U) and a second threshold value (10) for the electric current intensity (I) are defined in the memory (20), and the evaluation unit (18) is configured to ascertain a time interval (4) that comprises the duration between the first threshold value (8) being exceeded and the second threshold value (10) being fallen below, and **characterized in that** the evaluation unit (18) is further configured to compare the time interval (4) ascertained in this way with a reference value stored in the memory (20) and to compare a voltage profile measured during the time interval (4) with a reference voltage profile, in each case ascertained on an assembly in the new state.

10. Monitoring unit (14) according to Claim 9, **characterized in that** the evaluation unit (18) is configured to produce a signal (12) if the time interval (4) exceeds the reference value by a limit value.

11. Monitoring unit according to Claim 10, **characterized in that** a communication device (22) that is configured to transmit the signal (12) to a decentralized data processing device (24) is provided.

12. Electrical switchgear assembly (2) comprising a monitoring unit (14) according to Claim 10 or 11.

13. Electrical switchgear assembly (2) according to Claim 12, **characterized in that** the latter is configured to switch current intensities (I) of more than 16 kA.

## Revendications

1. Procédé de détermination de l'état d'une installation (2) électrique de coupure, dans lequel on mesure le courant (I) électrique et la tension (U) chutant aux bornes de l'installation (2) de coupure, **caractérisé en ce que** l'on détermine un intervalle (4) de temps d'un arc (6) électrique se produisant pendant une opération de coupure, dans lequel l'intervalle (4) de temps débute lorsque la valeur de la tension (U) mesurée dépasse une première valeur (8) de seuil et l'intervalle (4) de temps finit lorsque la valeur de l'intensité (I) du courant devient inférieure à une deuxième valeur (10) de seuil, **caractérisé en ce que** l'on compare l'intervalle (4) de temps ainsi déterminé à une valeur de référence, spécifique à l'installation (2) de coupure, qui a été déterminée par les mêmes méthodes dans une installation à l'état neuf et l'on compare la différence (Δt) de temps de l'intervalle de temps déterminé et de la valeur de référence, et l'on mesure la courbe (U(t)) de tension pendant l'intervalle (4) de temps et on la compare à une courbe de tension de référence mesurée sur une installation à l'état neuf.

2. Procédé suivant la revendication 1, **caractérisé en ce que** la mesure de la tension (U) s'effectue au moins toutes les 1 ms.

3. Procédé suivant l'une des revendications 1 à 2, **caractérisé en ce que** la mesure du courant (I) s'effectue au moins toutes les 1 ms.

4. Procédé suivant l'une des revendications précédentes, **caractérisé en ce que** l'on fixe la valeur de référence, fixée pour l'installation (2) de coupure, en fonction de l'intensité (Iₘₐₓ) de courant maximum, qui, lorsque l'installation (2) de coupure est à l'état fermé, s'y applique.

5. Procédé suivant l'une des revendications précédentes, **caractérisé en ce que** l'on détermine la courbe de la tension de référence en fonction de l'intensité (Iₘₐₓ) de courant maximum, qui, lorsque l'installation (2) de coupure est à l'état fermé, s'y applique.

6. Procédé suivant l'une des revendications 4 ou 5, **caractérisé en ce que** l'intensité (Iₘₐₓ) de courant maximum, qui, lorsque l'installation de coupure est à l'état fermé, s'y applique, est d'au moins 16 A.

7. Procédé suivant l'une des revendications précédentes, **caractérisé en ce qu'**on crée un signal (12), si l'intervalle (4) de temps dépasse la valeur de référence d'une valeur limite.

8. Procédé suivant la revendication 7, **caractérisé en ce qu'**on crée le signal, si l'intervalle de temps dépasse la valeur de référence de 10 %.

9. Unité (14) de contrôle d'une installation (2) électrique de coupure comprenant une unité (16) de mesure pour la mesure de l'intensité (I) du courant passant dans l'installation de coupure et de la tension (U) chutant aux bornes de l'installation (2) de coupure, ainsi qu'une unité (18) d'analyse comprenant une mémoire (20), dans laquelle on fixe dans la mémoire (20) une première valeur (8) de seuil de la tension (U) appliquée ainsi qu'une deuxième valeur (10) de seuil de l'intensité (I) du courant électrique et l'unité (18) d'analyse est conformée pour effectuer une détermination d'un intervalle (4) de temps, qui comprend la durée entre le surdépassement de la première valeur (8) de seuil et le sous-dépassement de la deuxième valeur (10) de seuil, **caractérisée en ce que** l'unité (18) d'analyse est conformée en outre pour équilibrer l'intervalle (4) de temps ainsi déterminée avec une valeur de référence mise dans la mémoire (20), ainsi que pour équilibrer une courbe de tension mesurée pendant l'intervalle (4) de temps avec une courbe de tension de référence déterminée respectivement sur une installation à l'état neuf.

10. Unité (14) de contrôle suivant la revendication 9, **caractérisée en ce que** l'unité (18) d'analyse est conformée pour produire un signal (12), si l'intervalle (4) de temps devient inférieur à la valeur de référence d'une valeur limite.

11. Unité de contrôle suivant la revendication 10, **caractérisée en ce qu'**il est prévu un système (22) de communication, qui est conformé pour transmettre le signal (12) à une installation (24) centrale de traitement des données.

12. Installation (2) électrique de coupure comprenant une unité (14) de contrôle suivant la revendication 10 ou 11.

13. Installation (2) électrique de coupure suivant la revendication 12, **caractérisée en ce que** celle-ci est conformée, de manière à faire passer des intensités (I) de courant de plus de 16 kA.
